# EUROPEAN PATENT SPECIFICATION

(11) **EP 0 420 516 B1**
(45) Date of publication and mention of the grant of the patent: **24.07.1996**
(21) Application number: 90310341.4
(22) Date of filing: 21.09.1990
(51) Int. Cl.: H01L 21/20, H01L 21/324

(54) **Method for forming semiconductor thin film**
Verfahren zur Herstellung einer Halbleiterdünnschicht
Procédé pour former un film fin semi-conducteur

(30) Priority: 23.09.1989 JP 247662/89
(43) Date of publication of application: 03.04.1991
(73) Proprietor: CANON KABUSHIKI KAISHA, Tokyo (JP)
(72) Inventor: Yonehara, Takao, c/o Canon Kabushiki Kaisha, Ohta-ku, Tokyo (JP)
(74) Representative: Beresford, Keith Denis Lewis

(56) References cited:
- WO-A-89/04550
- EXTENDED ABSTRACTS OF THE 20TH (1988 INTERNATIONAL) CONFERENCE ON SOLID STATE DEVICES AND MATERIALS, Tokyo, 24th - 26th August 1988, pages 185-88; E. MURAKAMI et al.: "Crystal defect study of solid phase epitaxially grown Si surrounded by SiO2 structures"
- JAPANESE JOURNAL OF APPLIED PHYSICS, vol. 23, no. 10, part I, October 1984, pages 1294-1299, Tokyo, JP; M. TAMURA et al.: "Characterization of solid-phase epitaxially-grown silicon films on Si02"
- JOURNAL OF APPLIED PHYSICS, vol. 64, no. 4, 15th August 1988, pages 2069-2075, Woodbury, NY, US; S. DASGUPTA et al.: "Two-beam laser recrystallization of polycrystalline silicon on an insulating substrate"
- THIN SOLID FILMS, vol. 167, no. 1, 15th December 1988, pages 101-106, Lausanne, CH; E. KORIN et al.: "Crystallization of amorphous silicon films using a multistep thermal annealing process"
- JOURNAL OF APPLIED PHYSCIS, vol. 64, no. 6, 15th September 1988, pages 3018- 3023, Woodbury, NY, US; M. MIYAO et al.: "Low-temperature SOI (Si-on-insulator) formation by lateral solid-phase epitaxy"

## Description

The present invention relates to a method for forming a semiconductor thin film applied to, for example, structural elements of a three dimensional integrated circuit or a large area electronic element. In particular it concerns a method of producing large-grained polycrystalline silicon thin film.

In the past, the method for growing a solid phase by exposing an amorphous thin film previously formed on a substrate to a thermal treatment at low temperature below the melting point has been proposed as a method for forming a crystalline thin film on an amorphous substrate.

For example, there has been reported the technique in which a polycrystalline Si thin film having a grain size of 5 µm can be formed according to the procedure comprising effecting a solid phase growth by exposing an amorphous Si thin film having a film thickness of about 100 nm formed on amorphous SiO₂ and modified to amorphous state by ion implantation, to thermal treatment at 600°C for several ten hours under N₂ atmosphere, whereby the amorphous Si thin film is crystallized. (T. Noguti, H.Hayashi and H. Ohshima, 1987, Mte. Res. Soc. Symp. Proc. 106, Polysilicon and Interfaces, 293, Elsevier Science Publishing, New York 1899)

The grain size of the polyorystalline thin film obtained by this method is about 100 times larger than that of the polycrystal film deposited by a reduced pressure CVD method. Therefore, it is possible to make a high performance electronic element on the thin film. For example, the electron mobility of a field effect transistor (MOSFET) formed on the thin film obtained by the above method is several times to several ten times higher than that of MOSFET formed on the polycrystal thin film deposited by the reduced pressure CVD method as such. More concretely, when a P channel or N channel MOSFET is produced, the carrier mobility of the latter is about 50 cm²/V·sec and that of the former is 100 cm²/V·sec.

However, the inventor found that this technique had the problems described below. That is, it was surmised that a large amount of crystal defects were present inside each crystal grain since the crystal growing pattern in this technique was the dendritic growth effected by introducing a twin crystal grain boundary and indeed, as the result of actual observation of the crystallographic structure by using a transmission electron microscope, the inventor found that the large amount of defect groups existed and the carrier mobility was restricted.

On the other hand, high temperature local thermal treatment employing an energy beam (coherent light (laser light), electron beam, ion beam, etc.) has been reported as a technique for growing a crystal on an amorphous insulator substrate. In this method, crystallization is achieved by focusing an energy beam and heating a local area to nearly the melting point. Due to the local heating, the process essentially can be a low temperature process without rising the temperature of the whole substrate. However, the local heating causes many problems with relation to productivity and controllability both. The reason is as follows. For thermally treating the whole surface of a substrate with large area, it is absolutely necessary to scan a beam. In addition, a long time is required for treating uniformly the large area since it is necessary to finely adjusting the degree of overlap of a beam the depth of a focus, etc. during the beam scanning.

The present invention is intended as a solution to the problems just discussed.

In accordance with the present invention there is provided a method of producing a large-grained polycrystalline silicon thin film having a grain size of micrometer order, which method comprises:
providing an amorphous silicon thin film having a thickness of about 0.1 µm on a continuous SiO₂ surface;
heating said amorphous silicon thin film at a temperature which is sufficient to effect solid phase growth but which does not exceed 700°C, said heating being performed for a time, not less than ten hours, sufficient to complete solid phase growth, thereby to convert said amorphous silicon thin film to a polycrystalline silicon thin film; and
irradiating the whole film area of said polycrystalline silicon thin film with a lamp to anneal it at a temperature of not less than 1200°C for a time of between one and three minutes inclusive, to reduce the number of crystal defects in the grains of said polycrystalline silicon thin film without changing the size of said grains.

The method just described is advantageous in that it achieves large grain size with few intra grain defects, with uniformity over large area.

The annealing step takes little time to perform and therefore overall the production time can be relatively short.

While the above method involves two stages of heat treatment it is mentioned that Japanese Journal of Applied Physics Vol 23, No. 10, pages 1294-1299 (October 1984) also describes a method involving similar stages of heat treatment. It is however directed to epitaxial lateral overgrowth in which single crystal thin film is grown from an exposed seeding area of an underlying monocrystal substrate. It does not concern the controlled growth of large-grained low defect polycrystalline thin film as in the present instance.

### BRIEF DESCRIPTION OF THE DRAWINGS

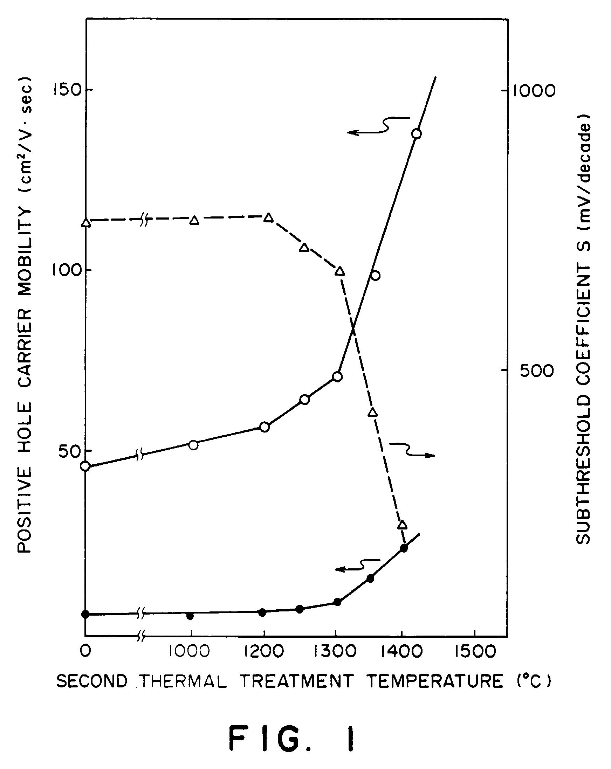

Fig. 1 is a graphic chart showing the influence of the heating temperature in a second thermal treatment upon the element properties.

### DETAILED DESCRIPTION OF THE PREFERRED EMBODIMENTS

The following description is for explaining in detail the effect and constitution of the present invention with the knowledge obtained in the course of accomplishing the present invention.

During a thermal treatment in which a lamp light was radiated to an amorphous Si thin film, the inventor observed carefully the crystal structure of a large amount of samples before and after the radiation by using a transmission electron microscope to obtain the important results described below.
A) A tungsten halogen lamp light (0.5 to 3.5 µm in wavelength) was directly radiated to an amorphous Si thin film and this film was heated to 1100°C or higher for 1 to 3 minutes, whereby the film was crystallized. Especially, by a heating treatment at 1200°C or higher, a polycrystalline thin film having a grain size of 1 µm or less was formed. Inside the grain, an equal inclination interference fringe pattern was observed. Therefore, it was found that the thin film had less defects.
B) An amorphous Si thin film was exposed to a thermal treatment at 700°C for 10 to 100 hours to effect a solid phase growth. After a large grain size dendritic crystal of 1 µm or more in a grain size was grown, a light irradiation by a lamp was conducted at a temperature of 1100°C or higher to decrease the amount of crystal defect in the grain (lamination defect, micro twin crystal, transposition, vacancy, etc.) as described in the above item A). Especially, it was found that the amount of crystal defect was remarkably decreased by the thermal treatment at 1200°C or higher. Further, in this case, it should be noted that movement and disappearance of the grain boundary were not observed.
C) In the items A) and B), it was found that as the temperature was elevated to 1300°C, 1400°C and higher (heating time: 3 minutes), the amount of defect in the grain was decreased. These phenomena are understood as described as follows.

In the case of the item A), the amorphous Si thin film is heated at a stroke to 1100°C or higher, whereby the nucleation rate in the solid phase becomes higher than that in the item B) and the grain size determined by the grain boundary formed by collision between the grains becomes minute, 1 µm or less. Further, it is inferred that the movement and disappearance of defects are caused by decrease of the free energy of the defects as a driving force. At the same time, the grain growth is also effected by decrease of the grain boundary energy as a driving force.

In the item B), since the low temperature annealing is caused, the nucleation rate in a solid phase is restricted slow, whereby the grain size becomes 1 micrometer or more under the thermal treatment at 700°C or lower for 10 hours. That is, the dendritic polycrystal with a large grain size is grown and then heated to 1200°C using a lamp, whereby the movement and disappearance of defect groups are caused by decrease of the defect energy inside the grain as a driving energy. However, the maximal grain size is as large as 1 µm or more, the state of grain boundary energy is lower than that in the item A) and a grain growth with movement of a grain boundary is not effected. A transistor (P channei field effect transistor) was formed in the Si thin film modified to the crystal structure which was uniform over a large area. In Fig. 1, positive hole carrier mobility and subthreshold property are plotted vs. a lamp heating temperature. The plot of the black circle mark (●) shows the data concerning the sample of the item A) in which the MOSFET is formed in the film formed by directly treating amorphous Si at a high temperature by lamp heating. The positive hole carrier mobility shows less change and is 10 cm²/V·sec or less in the thermal treatment at a temperature lower than 1200°C. However, in the thermal treatment at 1300°C or higher, the mobility is rapidly improved to be more than 10 cm²/V·sec. The subthreshold coefficient is 1000 mV/decade or more. Therefore, the quality is so inferior that the plot is outside the graph.

The white circle mark (○) shows the change of the positive hole carrier mobility of the sample of the above item B) in which solid phase growth of an amorphous Si thin film is effected at a low temperature to make a large grain size of 1 µm or more and then a lamp light is radiated, and MOSFET is prepared therein. The triangle mark (Δ) shows the change of subthreshold coefficient. Even to a transistor, which is formed in a film formed by a low temperature solid phase growth as such, before a lamp radiation, the carrier mobility is more than 40 cm²/V·sec. Further, the mobility is gently increased up to 1200°C to become 58 cm²/V·sec.

Further, by a heating using a light irradiation at 1200°C or higher, the mobility is dramatically increased. At 1400°C or higher, it becomes 140 cm²/V·sec and is greatly improved. It is found that the mobility is remarkably increased in particular at 1300°C or higher. On the other hand, the subthreshold property is 700 mV/decade up to 1200°C, the decrease in this property occurs at 1200°C or higher, and a particularly remarkable improvement is found at 1300°C or higher.

To sum up, the semiconductor amorphous thin film is exposed to a first treatment at 700°C or lower for 10 hours or longer to lower the nucleation rate in the solid phase and grow a dendritic crystal having a large grain size of a micrometer order in a maximal grain size. Next, the thermal treatment at 1200°C or higher (the thermal treatment carried out by radiating a lamp light to the whole film area) causes decrease of the crystal defects inside the grain without changing the size of the grain grown by the first thermal treatment, whereby the device property is improved. Thus, the present invention has been accomplished.

However,the first thermal treatment is carried out at a temperature of 700°C or lower, since this treatment at higher than 700°C grows the polycrystalline thin film having a maximal grain size of 1 µm or less. The lower limit temperature is the temperature sufficient to effect a solid growth. Concretely, since determination of the temperature is affected by a material of an amorphous thin film, etc., it is desirable to determine it by previously carrying out an experiment, etc. On the other hand, progress of solid phase growth is not completed in case of a first thermal treatment time below 10 hours. Therefore, since it is feared that an amorphous state remains, the treatment is carried out for 10 hours or more.

In the second thermal treatment, heating is applied using a lamp to irradiate the whole film area. By such lamp heating, the temperature is raised to 1200°C or higher in a very short time (several seconds). Temperature falling is also performed very rapidly. Further, suitable selection of the wavelength makes possible selective heating of only Si thin film, whereby defects inside the grain can be efficiently decreased. In these two points, the use of lamp light is advantageous over the electric furnace method used generally. Especially, heating at 1200°C or higher is difficult in the electric furnace method. Further, with regard to uniformity over a large area, the present invention is markedly improved compared with the laser heating method (scanning).

It is preferable that the polycrystalline semiconductor thin film (formed by the first thermal treatment) is covered by a capping material before being exposed to the second thermal treatment. By providing a capping material, a flatter film surface can be achieved.

It is preferable that the capping material is SiO₂ or Si₃N₄ formed by sputtering. Further, it is preferable that the thickness is from 10 nm to 100 nm.

On the other hand, for controlling precisely the grain size, the temperature rising rate to the second thermal treatment temperature is preferably 100°C/sec to 500°C/sec, The heating time in the second thermal treatment is 1 to 3 minutes.

The first thermal treatment temperature described above is preferably 60 percent or lower of the melting point (Kelvin unit) of the semiconductor material in the amorphous semiconductor thin film. Similarly, the second thermal treatment temperature is preferably 85 percent or higher of the melting point (Kelvin unit) of the above semiconductor material.

### EXAMPLE

### Example 1

On a substrate in which SiO₂ thermal oxidization film with 0.1 µm thick is grown on a Si wafer, a polycrystalline Si film of 0.1 µm in thickness was formed by the reduced pressure CVD method (chemical vapor deposition method) at 620°C under 0.4 hPa (0.3 Torr). SiH₄ was employed as a source gas.

Si⁺ ion of 3x10¹⁵ cm⁻² in implantation quantity was implanted into the whole region of the polycrystalline Si thin film under 40 KeV in implantation energy to modify the polycrystalline Si thin film to amorphous state.

Next, thermal treatment was carried out using an electric furnace under N₂ at 600°C for 50 hours (first thermal treatment) to grow a dendritic large grain size crystal (polycrystalline Si thin film). The grain size of this polycrystalline Si thin film was observed to be 0.1 to 5 µm.

Tungsten halogen lamp light was radiated to both the surfaces of the polycrystalline Si thin film so that the Si wafer became 1400°C at 200°C/sec in temperature rising rate, and the temperature was maintained for 1 minute (second thermal treatment). The grain size of the polycrystalline Si thin film thus formed was observed to be 0.1 to 5 µm, and the distribution of the grain size showed no change before and after the second thermal treatment.

In this Example, for preventing formation of a surface roughness of a thin film caused during lamp irradiation, SiO₂ ( capping material) with 50 nm was sputtered to cap the surface of the polycrystalline thin film. The capping material was removed, and the surface roughness was measured. The surface roughness was within several nanometers (ten angstroms).

On the thin film thus formed, a P channel MOSFET of polysilicon gate was prepared according to the IC process. The mobility was 140 cm²/V·sec.

### Example 2

On a quartz substrate, an amorphous Si thin film of 0.1 µm in thickness was formed by the reduced pressure CVD method. The deposition temperature was 550°C and the pressure was 0.4 hPa (0.3 Torr).

Si⁺ ion was impregnated over the whole surface of this amorphous Si thin film at 1x10¹⁵/cm² under 40 KeV.

Next, a thermal treatment was carried out in an electric furnace under N₂ at 600°C for 50 hours to effect a solid growth. The grain size of the grown polycrystalline Si film was 0.1 to 5 µm.

On this thin film, SiO₂ (capping material) was coated by sputtering and then heated to 1400°C at 200°C/sec in temperature rising rate using a tungsten halogen lamp as described in Example 1 with a Si wafer being contacted as a light absorbing material. This light heating was maintained for 1 minute. The grain size of the thin film thus formed was 0.1 to 5 µm.

The capping SiO₂ sputtered film was removed and a P channel MOSFET was prepared according the general IC process. The mobility was 140 cm²/V·sec.

### Example 3

An amorphous Si film of 0.1 µm in thickness was deposited by vacuum vapor deposition on a thermal oxidation film of 0.1 µm in thickness formed on a Si wafer. The degree of vacuum and deposition rate were 4.10⁻⁹ hPa (3x10⁻⁹ Torr) and 0.02 nm/sec, respectively. The temperature of the substrate was 300°C during the vapor deposition. This amorphous Si film was exposed to the thermal treatment in an electric furnace under N₂ at 600°C for 50 hours. After the dendritic polycrystal having a large grain size of 1 µm or more was grown, a SiO₂ sputtered film of 50 nm in thickness was coated as a cap. Both the surfaces were heated by radiating a tungsten halogen lamp light (wave length: 0.5 to 3.5 µm) at 200°C/sec in temperature rising rate at 1350°C for 2 minutes. The grain size of the thin film thus formed was about 3 µm. Next, a MOSFET was prepared according to the general IC process. The mobility was 100 cm²/V·sec.

## Claims

1. A method of producing a large-grained polycrystalline silicon thin film having a grain size of micrometer order, which method comprises:
providing an amorphous silicon thin film having a thickness of about 0.1 µm on a continuous SiO₂ surface;
heating said amorphous silicon thin film at a temperature which is sufficient to effect solid phase growth but which does not exceed 700°C, said heating being performed for a time, not less than ten hours, sufficient to complete solid phase growth, thereby to convert said amorphous silicon thin film to a polycrystalline silicon thin film; and
irradiating the whole film area of said polycrystalline silicon thin film with a lamp to anneal it at a temperature of not less than 1200°C for a time of between one and three minutes inclusive, to reduce the number of crystal defects in the grains of said polycrystalline silicon thin film without changing the size of said grains.

2. A method as claimed in claim 1 including a step of providing a capping material on said polycrystalline silicon thin film formed during said heating, which step is performed prior to said irradiating the whole film area.

3. A method as claimed in claim 2 wherein said capping material is silicon oxide or silicon nitride.

4. A method as claimed in either of claims 2 or 3 wherein said capping material has a thickness of 10 nm to 100 nm.

5. A method as claimed in any preceding claim wherein in irradiating said polycrystalline thin film the temperature of said polycrystalline thin film is raised to said temperature of not less than 1200°C at a rising rate of between 100°C/sec and 500°C/sec inclusive.

6. A method of producing a MOSFET field effect transistor in which said transistor is formed in and upon polycrystalline silicon thin film obtained by the method claimed in any one of the preceding claims 1 to 5.

## Patentansprüche

1. Verfahren zur Herstellung einer grobkörnigen polykristallinen Siliciumdünnschicht mit einer Korngröße im Mikrometerbereich, wobei das Verfahren die nachstehenden Schritte umfaßt:
Aufbringen einer amorphen Siliciumdünnschicht mit einer Dicke von ungefähr 0,1 µm auf eine zusammenhängende SiO₂-Oberfläche;
Erwärmen der amorphen Siliciumdünnschicht bei einer Temperatur, die ausreicht, um ein Festphasenwachstum zu bewirken, aber 700 °C nicht überschreitet, wobei das Erwärmen mit einer Zeitdauer erfolgt, nicht weniger als 10 Stunden, die ausreicht, um das Festphasenwachstum zu vollenden, und dadurch die amorphe Siliciumdünnschicht in eine polykristalline Siliciumdünnschicht umzuwandeln; und
Bestrahlen der gesamten Schicht fläche der polykristallinen Siliciumdünnschicht mit einer Lampe, um sie bei einer Temperatur von nicht niedriger als 1200 °C für eine Zeitdauer zwischen einer und drei Minuten einschließlich zu tempern, um die Zahl der Kristallfehler in den Körnern der polykristallinen Siliciumdünnschicht ohne Veränderung der Größe der Körner zu verringern.

2. Verfahren nach Anspruch 1, das einen Schritt der Aufbringung eines Abdeckmaterials auf der während der Erwärmung gebildeten polykristallinen Siliciumdünnschicht einschließt, wobei der Schritt vor der Bestrahlung der gesamten Schichtfläche erfolgt.

3. Verfahren nach Anspruch 2, wobei das Abdeckmaterial Siliciumoxid oder Siliciumnitrid ist.

4. Verfahren nach einem der Ansprüche 2 oder 3, wobei das Abdeckmaterial eine Dicke von 10 nm bis 100 nm aufweist.

5. Verfahren nach einem der vorstehenden Ansprüche, wobei beim Bestrahlen der polykristallinen Dünnschicht die Temperatur der polykristallinen Dünnschicht mit einer Temperaturanstiegsrate zwischen 100 °C/sec und 500 °C/sec einschließlich auf eine Temperatur von nicht niedriger als 1200 °C erhöht wird.

6. Verfahren zur Herstellung eines MOSFET-Feldeffekt-transistors, in dem der Transistor in und auf einer durch das Verfahren nach einem der vorstehenden Ansprüche 1 bis 5 erhaltenen, polykristallinen Siliciumdünnschicht gebildet wird.

## Revendications

1. Procédé de production d'un mince film de silicium polycristallin à grain de grand diamètre, ayant un diamètre de grain de l'ordre du micromètre, procédé qui comprend les étapes consistant :
à former un mince film de silicium amorphe ayant une épaisseur d'environ 0,1 µm sur une surface continue de SiO₂ ;
à chauffer ce mince film de silicium amorphe à une température qui est suffisante pour l'accomplissement de la croissance de la phase solide et qui ne dépasse pas 700°C, ce chauffage étant conduit pendant une durée, non inférieure à 10 heures, suffisante pour terminer la croissance de la phase solide, de manière à convertir le mince film de silicium amorphe en question en un mince film de silicium polycristallin ; et
à irradier entièrement la surface du mince film de silicium polycristallin avec une lampe pour le recuire à une température non inférieure à 1200C° pendant une durée comprise entre 1 et 3 minutes inclus, afin de réduire le nombre de défauts cristallins dans les grains du mince film de silicium polycristallin sans modifier le diamètre de ces grains.

2. Procédé suivant la revendication 1, comportant une étape de mise en place d'une matière de recouvrement sur le mince film de silicium polycristallin formé pendant le chauffage, cette étape étant exécutée avant l'irradiation de la surface entière du film.

3. Procédé suivant la revendication 2, dans lequel la matière de recouvrement est de l'oxyde de silicium ou du nitrure de silicium.

4. Procédé suivant la revendication 2 ou 3, dans lequel la matière de recouvrement a une épaisseur de 10 nm à 100 nm.

5. Procédé suivant l'une quelconque des revendications précédentes, dans lequel la température du mince film polycristallin lors de l'irradiation de ce film est élevée jusqu'à une valeur non inférieure à 1200°C à une vitesse d'élévation comprise entre 100°C/s et 500°C/s inclus.

6. Procédé de production d'un transistor à effet de champ MOSFET, dans lequel ce transistor est formé dans et sur un mince film de silicium polycristallin obtenu par le procédé selon l'une quelconque des revendications 1 à 5.
